Europäisches Patentamt

**European Patent Office**

**Office européen des brevets**

(11) Publication number: **0 037 154**
**A1**

# EUROPEAN PATENT APPLICATION

(21) Application number: **81200338.2**

(22) Date of filing: **26.03.81**

(51) Int. Cl.³: **H 01 H 11/04**

(30) Priority: **27.03.80 US 134683**

(43) Date of publication of application:
**07.10.81 Bulletin 81/40**

(84) Designated Contracting States:
**AT BE CH DE FR GB IT LI LU NL SE**

(71) Applicant: **E.I. DU PONT DE NEMOURS AND COMPANY**
**Legal Department 1007 Market Street**
**Wilmington, Delaware 19898(US)**

(72) Inventor: **Schell, Mark Samuel**
**931 Sanborn Drive**
**Palatine Illinois 60067(US)**

(74) Representative: **van der Beek, George Frans et al,**
**Nederlandsch Octrooibureau Johan de Wittlaan 15 P.)**

(54) **Process for inserting gold dot in electrical terminals.**

(57) Gold dots (22) are punched from a plated gold strip (24), inserted into a prepared hole (18) in a solder coated electrical terminal contact area (10). Heat is applied to the terminal (10) to reflow the solder (30) and seal the interface (16) between the dot and the terminal hole.

EP 0 037 154 A1

./...

Fig. 3

## Title

PROCESS FOR INSERTING GOLD
DOT IN ELECTRICAL TERMINALS

### Background of the Invention

#### Field of the Invention

This invention relates to a method of inserting a first metal structure into a second metal structure. More specifically, it refers to a process of inserting a gold dot into the contact area of an electrical terminal.

#### Description of the Prior Art

The need to keep electrical contact areas free from corrosive effects limits the number of metals useful in these contact areas. The preferred metal for high quality contacts is gold. Unfortunately, the high cost of gold is a severe limitation to its use. Methods have been developed to restrict the use of gold to a minimum by employing gold only in the contact areas of terminals. Heretofore, the gold has been applied as a "drop" or a "stripe" in the contact surface area. The drop method usually applies about .001" of gold in the contact area. However only about 30 microinches is needed. Stripes can be plated onto contact areas of terminals at a 30 microinch thickness but the equipment to perform this operation is not cost effective. Moreover plated stripes are wasteful of gold when electrical terminal configuration requires large spaces between contact points.

A cost effective method is needed to create a contact surface on a terminal having only 30 microinches of gold.

### Summary of the Invention

In accordance with this invention I have discovered a simple, cost effective method of placing

.-4187

about 30 microinches of gold on terminal contact zones. The method involves plating a strip of electrically conductive metal such as berrylium copper, copper, bronze or phosphor bronze with a layer of about 30 microinches of gold. Conventional plating techniques can be used. Subsequently a terminal base material made from a conductive metal such as berrylium copper, copper, bronze or phosphor bronze is stamped by conventional methods to form terminals on a carrier strip. Included in this stamping is a hole punched out in the proposed terminal contact zone. A layer of solder is plated to the surface of the terminals either before or subsequent to the stamping step. A dot is punched from the gold plated strip of metal and this dot is inserted by the punch into the hole in the terminal contact zone. Heat is thereafter applied to the terminal strip to reflow the solder and seal the interface between the dot and the terminal hole.

Brief Description of the Drawings

FIG. 1 is a cross sectional view of the gold dot inserted into a hole on a terminal contact zone.

FIG. 2 is a perspective view of the gold dot being punched from a plated metal strip.

FIG. 3 is a perspective view of the gold dot being inserted into the hole on a terminal carrier strip.

Description of the Preferred Embodiments

The invention comprises a method of inserting a gold dot 22 punched from a plated strip 24 of a conductive metal base material into a hole 18 prepunched from a terminal strip 28.

Any of the conventional gold plating methods such as described in U.S. Patent 3,427,231 could be used to plate the strip 24 with a thin layer of gold 12. The gold should be preferably at least 18 karats.

The plated strip 24, having a layer of gold 12, about 30 microinches thick over a bronze, phosphor bronze, copper or berrylium copper substrate is struck with a punch 20. A support 26 pushes the cut disk 22 away from the strip 24. The diameter of the punched disk will coincide with the diameter of the hole 18 punched from the terminal 10.

The terminal carrier strip 28 has a series of terminals 10 stamped at the same time that the hole 18 is punched out. The strip 24 is fed into the die and the disk 22 is simultaneously punched from the strip 24 and inserted into the hole 18 in a terminal 10. The disk 22 is held in the hole 18 by an interference fit. Additional pressure is exerted to effect a cold weld between the disk 22 and the terminal 10. Heat may also be applied to promote a bond by diffusion, brazing or soldering.

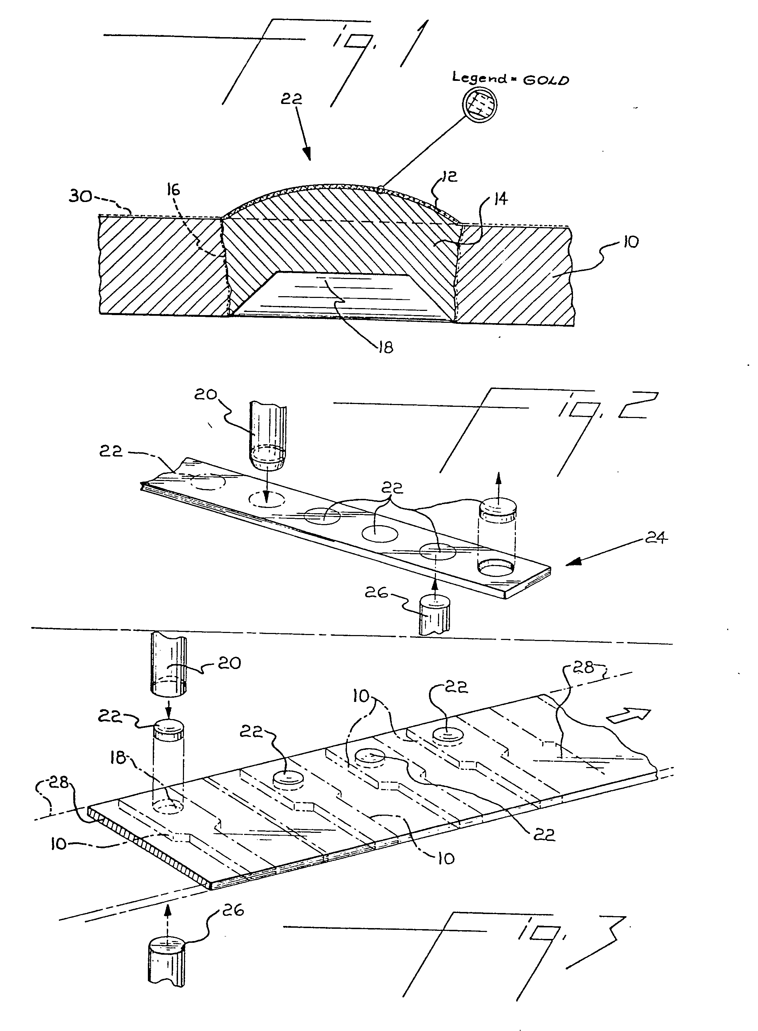

In the preferred embodiment the surface of terminal 10 is coated with solder 30. After inserting the disk 22 into the hole 18, the terminal 10 is heated above the melting point of the solder to cause a flow of solder to move into the joint 16 between the disk 22 and the terminal 10. (See FIG. 1) This insures a firm seal under most stress conditions encountered by a terminal contact area.

Gold plating from the scrap terminal carrier strip 28 can be recovered by conventional means.

The terminals can be used in high quality electrical devices requiring continuous electrical contact without formation of oxides which lower contact efficiency. Typical devices include computers and military electronic equipment.

C L A I M S

1. A process for producing electrical terminals containing a thin layer of gold in the contact area, said process comprising

a) stamping electrical terminals (10) on a carrier strip (28) and simultaneously punching a hole (18) in each terminal (10) in the contact zone,

b) gold plating a base material (24) of about the same thickness as said terminals,

c) punching a multiplicity of disks (22) from said plated base material (24), the disks having about the same diameter as the holes (18) punched in said terminals (10) and

d) inserting a disk (22) into each hole (18) in said terminals (10).

2. The process according to claim 1 wherein said disks (22) are inserted into corresponding holes (18) in said terminals (10) by pressure to effect a cold weld.

3. The process according to claim 1 wherein the terminals (10) are coated with solder (30) and are heated after the disk (22) is inserted in the hole (18) to a temperature above the melting point of said solder (3) to effect a solder joint (16) between each disk (22) and each terminal (10).

4. The process according to claim 1 wherein the base material (24) is plated with about 30 microinches of gold.

5. The process according to claim 1 wherein the gold is at least 18 karats.

-.-.-.-

Fig. 1

Legend = GOLD

Fig. 2

Fig. 3

## EUROPEAN SEARCH REPORT

European Patent Office

### DOCUMENTS CONSIDERED TO BE RELEVANT

| Category | Citation of document with indication, where appropriate, of relevant passages | Relevant to claim |
|---|---|---|
| | <u>GB - A - 2 021 007</u> (JOHNSON, MATTHEY & CO.)<br><br>* Page 1, lines 127-130; page 2, lines 1-40 *<br><br>-- | 1,4 |
| | <u>US - A - 4 099 043</u> (J.J. ROZMUS)<br><br>* Column 2, lines 56-70; column 3, lines 1-10 *<br><br>-- | 1,3 |
| | <u>US - A - 2 755 368</u> (G.M.C.)<br><br>* Column 2, lines 4-72; column 3, lines 1-23 *<br><br>-- | 1 |
| | <u>US - A - 2 580 910</u> (S & C ELECTRIC CY)<br><br>* Column 3, lines 42-75; column 4, lines 1-24 *<br><br>-- | 3 |
| | <u>US - A - 2 715 169</u> (MINNEAPOLIS HONEYWELL REGULATOR COMP.)<br><br>* Column 2, lines 14-72; column 3, lines 1-36 *<br><br>-- | 1,2 |
| | <u>FR - A - 1 045 991</u> (L.M. ERICSSON)<br><br>* Page 1, column 2, paragraphs 4-7; page 2, column 1 *<br><br>-- | 1 |
| | <u>US - A - 2 937 434</u> (GENERAL CONTROLS CO.)<br><br>* Page 1, column 1, lines 59-72; column 2, lines 1-66 * | 1 |

CLASSIFICATION OF THE APPLICATION (Int Cl ¹)

H 01 H 11/04

TECHNICAL FIELDS SEARCHED (Int Cl ³)

H 01 H 11/04

CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 15-07-1981 | JANSSENS DE VROOM |

EPO Form 1503.1   06.78